(19) Europäisches Patentamt
European Patent Office
Office européen des brevets

(11) **EP 4 184 190 A1**

(12) **EUROPÄISCHE PATENTANMELDUNG**

(43) Veröffentlichungstag:
**24.05.2023  Patentblatt 2023/21**

(21) Anmeldenummer: **21209915.4**

(22) Anmeldetag: **23.11.2021**

(51) Internationale Patentklassifikation (IPC):
**G01R 31/68** (2020.01)        **G01R 27/20** (2006.01)
**G01R 27/16** (2006.01)        **B25F 5/00** (2006.01)

(52) Gemeinsame Patentklassifikation (CPC):
**G01R 31/68; G01R 27/205;** G01R 27/16

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Hilti Aktiengesellschaft
9494 Schaan (LI)**

(72) Erfinder:
• **Mayer, Stefan
86857 Hurlach (DE)**

• **Hauser, Klaus
86830 Schwabmünchen (DE)**
• **Frenzel, Mathias
86944 Unterdießen (DE)**
• **Koscheck, David
86899 Landsberg (DE)**

(74) Vertreter: **Hilti Aktiengesellschaft
Corporate Intellectual Property
Feldkircherstrasse 100
Postfach 333
9494 Schaan (LI)**

(54) **VERFAHREN ZUM BESTIMMEN DER KONDUKTIVITÄT EINES ELEKTRISCHEN LEITERS ZWISCHEN EINER ERSTER SYSTEMKOMPONENTE UND EINER ZWEITEN SYSTEMKOMPONENTE**

(57)    Verfahren zum Bestimmen der Konduktivität eines elektrischen Leiters zwischen einer erster Systemkomponente und einer zweiten Systemkomponente, wobei die erste und zweite Systemkomponente voneinander wiederlösbare Bestandteile eines Systems sind und wobei die erste Systemkomponente beispielsweise in Form eines Akkumulators und die zweite Systemkomponente beispielsweise in Form einer mit dem Akkumulator verbindbaren Werkzeugmaschine oder einer mit dem Akkumulator verbindbaren Ladevorrichtung ausgestaltet ist.

Das Verfahren enthält die Verfahrensschritte:
- Ermitteln eines ersten Spannungswertes und zweiten Spannungswertes an der ersten oder zweiten Systemkomponente bei einem gegebenen Stromstärkewert;
- Ermitteln eines ersten Differenzwertes zwischen einem Referenzspannungswert an der ersten Systemkomponente und dem ersten Spannungswert;
- Ermitteln eines zweiten Differenzwertes zwischen einem Referenzspannungswert an der ersten Systemkomponente und dem zweiten Spannungswert;
- Bestimmen eines Übergangwiderstands als Quotient aus dem zweiten Differenzwert und dem Stromstärkewert, wenn ein Unterscheid zwischen dem ersten und zweiten Differenzwert einen vorbestimmten Schwellwert erreicht; und
- Einstellen der ersten und/oder zweiten Systemkomponente von einem ersten Betriebszustand in einen zweiten Betriebszustand und/oder Aussenden wenigstens eines Signals durch eine Anzeigevorrichtung () an der ersten und/oder zweiten Systemkomponente, wenn der Übergangwiderstand einen vorbestimmten Schwellwert erreicht

System mit einer ersten und zweiten Systemkomponente zur Durchführung des erfindungsgemäßen Verfahrens, wobei die erste Systemkomponente beispielsweise in Form eines Akkumulators und die zweite Systemkomponente beispielsweise in Form einer mit dem Akkumulator verbindbaren Werkzeugmaschine oder einer mit dem Akkumulator verbindbaren Ladevorrichtung ausgestaltet ist. Die erste und/oder zweite Systemkomponente enthält eine Vorrichtung zum Ermitteln eines Spannungswertes, eine Vorrichtung zum Ermitteln eines Stromstärkewertes, eine Speichervorrichtung sowie eine Steuerungsvorrichtung.

EP 4 184 190 A1

Fig. 1

4
4c
4a
4b
2
8
5
4d
7
6a
6
1
6c
32a
31a
9
14
33a
13
23
6b
12
10
15b
15a
16a
11
22
18
16b
3
31b
21
17
20
33b
32b
19

**Beschreibung**

Die vorliegende Erfindung betrifft ein Verfahren zum Bestimmen der Konduktivität eines elektrischen Leiters zwischen einer erster Systemkomponente und einer zweiten Systemkomponente, wobei die erste und zweite Systemkomponente voneinander wiederlösbare Bestandteile eines Systems sind und wobei die erste Systemkomponente beispielsweise in Form eines Akkumulators und die zweite Systemkomponente beispielsweise in Form einer mit dem Akkumulator verbindbaren Werkzeugmaschine oder einer mit dem Akkumulator verbindbaren Ladevorrichtung ausgestaltet ist.

Darüber hinaus betrifft die vorliegende Erfindung auch ein System mit einer ersten und zweiten Systemkomponente zur Durchführung des erfindungsgemäßen Verfahrens, wobei die erste Systemkomponente beispielsweise in Form eines Akkumulators und die zweite Systemkomponente beispielsweise in Form einer mit dem Akkumulator verbindbaren Werkzeugmaschine oder einer mit dem Akkumulator verbindbaren Ladevorrichtung ausgestaltet ist.

Moderne kabellose Werkzeugmaschinen, wie beispielsweise Bohrhämmer, Sägen, Schrauber, Schleifgeräte oder dergleichen, sind mit einem oder mehreren Akkumulatoren verbindbar, die zur Versorgung der Werkzeugmaschine mit elektrischer Energie dienen. Akkumulatoren werden für gewöhnlich mit Ladevorrichtungen verbunden, um die im Inneren eines Akkumulators positionierten Energiespeicherzellen (auch Akkuzellen genannt) mit elektrische Energie zu versorgen.

Zum Stand der Technik gehören verschiedene Vorrichtungen zum Erfassen und zur Überwachung einzelner oder mehrerer Parameter eines Systems mit zwei oder mehreren Systemkomponenten. Bei den Systemkomponenten kann es sich um einen Akkumulator und einer mit dem Akkumulator verbundenen Werkzeugmaschine handeln. Alternativ kann das System aus einem Akkumulator sowie einer mit dem Akkumulator verbundenen Ladevorrichtung bestehen.

Um eine mögliche Fehlfunktion einer oder mehrerer Systemkomponenten festzustellen, werden die erfassten Parameter mit hinterlegten Schwellwerten verglichen. Wenn eine Fehlfunktion anhand des Parameterabgleichs festgestellt wird, können zum Verhindern eines größeren Schadens durch einen Totalausfall des Systems entsprechende Maßnahmen eingeleitet werden.

Nachteilig an diesen bereits bekannten Vorrichtungen ist jedoch, dass häufig zu spät ein schleichender bzw. sich stetig verschlechternder Zustand einer Systemkomponente mit Hilfe des Parameterabgleichs erkannt und eine oftmals daraus folgende Fehlfunktion oder Totalausfall durch Einleiten entsprechender Maßnahmen verhindert wird.

Es ist somit Aufgabe der vorliegenden Erfindung das vorstehend beschriebene Problem zu lösen und ein Verfahren bzw. ein System bereitzustellen, mit dem auf einfacher Art und Weise ein schleichender bzw. sich stetig verschlechternder Zustand einer Systemkomponente ermittelt werden kann.

Die Aufgabe wird gelöst durch den Gegenstand in Anspruch 1 und 4. Vorteilhafte Ausführungsformen sind in den Unteransprüchen aufgeführt.

Die Aufgabe wird gelöst durch ein Verfahren zum Bestimmen der Konduktivität eines elektrischen Leiters zwischen einer erster Systemkomponente und einer zweiten Systemkomponente, wobei die erste und zweite Systemkomponente voneinander wiederlösbare Bestandteile eines Systems sind und wobei die erste Systemkomponente beispielsweise in Form eines Akkumulators und die zweite Systemkomponente beispielsweise in Form einer mit dem Akkumulator verbindbaren Werkzeugmaschine oder einer mit dem Akkumulator verbindbaren Ladevorrichtung ausgestaltet ist.

Erfindungsgemäß sind die folgenden Verfahrensschritte vorgesehen:

- Ermitteln eines ersten Spannungswertes und zweiten Spannungswertes an der ersten oder zweiten Systemkomponente bei einem gegebenen Stromstärkewert;

- Ermitteln eines ersten Differenzwertes zwischen einem Referenzspannungswert an der ersten Systemkomponente und dem ersten Spannungswert;

- Ermitteln eines zweiten Differenzwertes zwischen einem Referenzspannungswert an der ersten Systemkomponente und dem zweiten Spannungswert;

- Bestimmen eines Übergangwiderstands als Quotient aus dem zweiten Differenzwert und dem Stromstärkewert, wenn ein Unterscheid zwischen dem ersten und zweiten Differenzwert einen vorbestimmten Schwellwert erreicht; und

- Einstellen der ersten und/oder zweiten Systemkomponente von einem ersten Betriebszustand in einen zweiten Betriebszustand und/oder Aussenden wenigstens eines Signals durch eine Anzeigevorrichtung () an der ersten und/oder zweiten Systemkomponente, wenn der Übergangwiderstand einen vorbestimmten Schwellwert erreicht.

Durch das Erreichen bzw. Anzeigen mit Hilfe der Anzeigevorrichtung, dass ein vorbestimmter Schwellwert für den Übergangwiderstand erreicht wurde, kann auf einfache Art und Weise ein schleichender bzw. sich stetig verschlechternder Zustand einer Systemkomponente ermittelt werden. Mechanische Spannungen bzw. Belastungen an stromführenden Leitern, insbesondere an Litzen, können häufig zu einer Verschlechterung der Konduktivität (auch elektrische Leitfähigkeit oder EC-Wert genannt) des elektrischen Leiters führen. Dies ist insbesondere der Fall, wenn der elektrische Leiter gestreckt wird und sich in Folge daraus die Querschnittsfläche reduziert. Der elektrische Leiter kann auch als Leitung oder elektrische Leitung bezeichnet werden.

Bei dem gegebenen Stromstärkewert handelt es sich um einen aktuell ermittelten Stromstärkewert zum Zeitpunkt des Ermittelns des ersten und zweiten Spannungswertes.

Bei dem Referenzspannungswert handelt es sich um einen Spannungswert als Referenz zu dem ersten und zweiten ermittelten Spannungswert. Es kann sich bei dem Referenzspannungswert beispielsweise um einen Nennspannungswert des Akkumulators handeln.

Gemäß einer vorteilhaften Ausgestaltung der vorliegenden Erfindung kann es möglich sein, dass der Verfahrensschritt enthalten ist:

- Ermitteln eines ersten Spannungswertes und zweiten Spannungswertes an wenigstens einem Leistungsanschluss, wobei der wenigstens eine Leistungsanschluss ein Bestandteil der ersten Systemkomponente oder der zweiten Systemkomponente ist.

Der Leistungsanschluss ist in einem elektrischen Leiter positioniert, sodass durch das Ermitteln der Konduktivität an dem Leistungsanschluss die Konduktivität des elektrischen Leiters ermittelt werden kann. Der elektrische Leiter kann auch als Leitung oder Litze bezeichnet werden.

Entsprechend einer weiteren vorteilhaften Ausgestaltung der vorliegenden Erfindung kann es möglich sein, das Ermitteln des zweiten Spannungswertes nach einer vorbestimmte Zeitdauer ab dem Ermitteln des ersten Spannungswertes erfolgt. Eine vorbestimmte Zeitdauer kann dabei zwischen 0,5 bis 2 Sekunden, und insbesondere 1 Sekunde betragen. Durch das zeitgesteuerte und in relativ kurzen Zeitabschnitten vorgenommene Ermitteln des zweiten Spannungswertes kann auch eine relativ schnelle Veränderung der Konduktivität sicher detektiert werden.

Des Weiteren wird die Aufgabe gelöst durch ein System mit einer ersten und zweiten Systemkomponente zur Durchführung des erfindungsgemäßen Verfahrens, wobei die erste Systemkomponente beispielsweise in Form eines Akkumulators und die zweite Systemkomponente beispielsweise in Form einer mit dem Akkumulator verbindbaren Werkzeugmaschine oder einer mit dem Akkumulator verbindbaren Ladevorrichtung ausgestaltet ist.

Erfindungsgemäß ist vorgesehen, dass die erste und/oder zweite Systemkomponente eine Vorrichtung zum Ermitteln eines Spannungswertes, eine Vorrichtung zum Ermitteln eines Stromstärkewertes, eine Speichervorrichtung sowie eine Steuerungsvorrichtung enthält.

Die erste Systemkomponente kann dabei in Form eines Akkumulators und die zweite Systemkomponente kann in Form einer Werkzeugmaschine ausgestaltet sein. Alternativ ist die zweite Systemkomponente in Form einer Ladevorrichtung ausgestaltet.

Der Akkumulator dient zur Versorgung der Werkzeugmaschine mit elektrischer Energie, wenn der Akkumulator und die Werkzeugmaschine miteinander verbunden sind. Des Weiteren kann der Akkumulator durch die Ladevorrichtung mit elektrischer Energie versorgt werden, wenn der Akkumulator und die Ladevorrichtung miteinander verbunden sind.

Weitere Vorteile ergeben sich aus der folgenden Figurenbeschreibung. In den Figuren sind verschiedene Ausführungsbeispiele der vorliegenden Erfindung dargestellt.

Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert. Es zeigen:

Figur 1     ein System gemäß einer ersten Ausführungsform mit einer Werkzeugmaschine als erste Systemkomponente und einem mit der Werkzeugmaschine verbundenen Akkumulator als zweite Systemkomponente;

Figur 2     ein System gemäß einer zweiten Ausführungsform mit einer Ladevorrichtung als erste Systemkomponente und dem mit der Ladevorrichtung verbundenen Akkumulator als zweite Systemkomponente;

Figur 3     eine Detailansicht auf die Leistungsanschlüsse der Werkzeugmaschine und des Akkumulators sowie auf die dazugehörigen Leitungen;

Figur 4     eine Detailansicht auf die Leistungsanschlüsse der Ladevorrichtung und des Akkumulators sowie auf die dazugehörigen Leitungen;

Figur 5     eine Detailansicht auf einen Leistungsanschluss in einem ersten Zustand;

Figur 6     eine weitere Detailansicht auf den Leistungsanschluss in einem zweiten Zustand; und

Figur 7     eine zusätzliche Detailansicht auf den Leistungsanschluss in einem dritten Zustand.

## Ausführungsbeispiele:

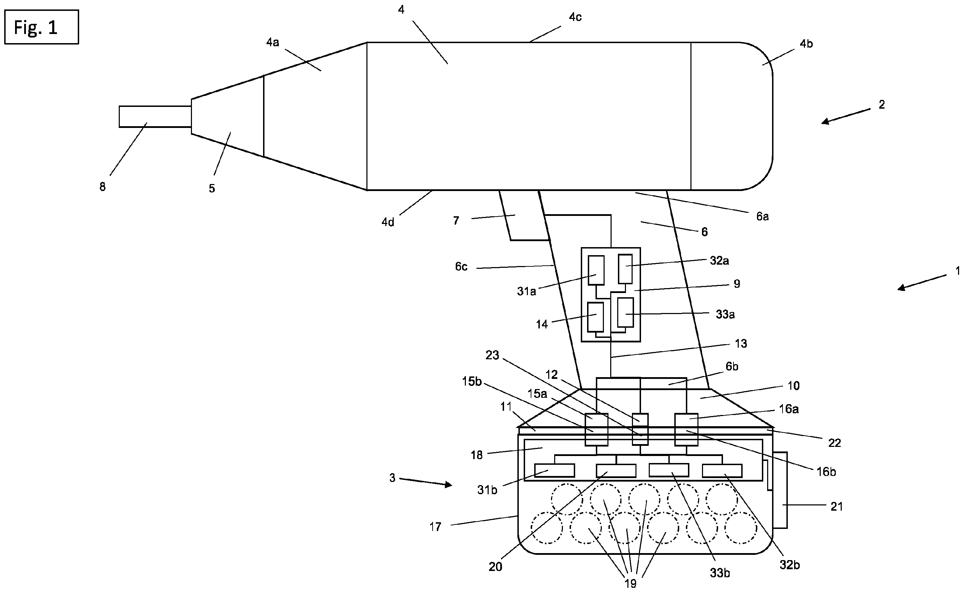

Figur 1 zeigt ein erfindungsgemäßes System 1 gemäß eines ersten Ausführungsbeispiels mit einer ersten Systemkomponente und einer zweiten Systemkomponente.

Gemäß dem ersten Ausführungsbeispiel ist dabei die erste Systemkomponente in Form einer Werkzeugmaschine 2 und die zweite Systemkomponente in Form eines Akkumulator 3 ausgestaltet. Die in Figur 1 dargestellte Werkzeugmaschine 2 ist dabei beispielsweise als Akku-Schrauber ausgestaltet. Die als Akkumulator 3 ausgestaltete zweite Systemkomponente ist in Figur 1 wiederlösbar mit der als Werkzeugmaschine 2 ausgestaltete erste Systemkomponente verbunden.

Alternativ kann die Werkzeugmaschine 2 auch als Bohrhammer, Bohrmaschine, Schleifgerät, Säge oder dergleichen ausgestaltet sein.

Wie ebenfalls in Figur 1 ersichtlich enthält die als Akku-Schrauber ausgestaltete Werkzeugmaschine 2 im Wesentlichen ein Werkzeuggehäuse 4, eine Werkzeugaufnahme 5 und einen Handgriff 6.

Der Handgriff 6 enthält wiederum ein oberes Ende 6a sowie ein unteres Ende 6b und dient zum Halten und Führen der Werkzeugmaschine 2 durch einen Anwender. An einer Vorderseite 6c des Handgriffs 6 ist ein Aktivierungsschalter 7 positioniert. Durch den Aktivierungsschalter 7 kann ein Anwender die Werkzeugmaschine 2 von einem Deaktivierungszustand in einen Aktivierungszustand einstellen. Der Aktivierungsschalter 6 enthält dabei ein Potentiometer (auch Poti genannt).

Der Anwender ist in den Figuren nicht gezeigt.

Das Werkzeuggehäuse 4 enthält wiederum ein vorderes Ende 4a, ein hinteres Ende 4b, eine Oberseite 4c und eine Unterseite 4d.

An dem vorderen Ende 4a des Werkzeuggehäuses 4 ist die Werkzeugaufnahme 5 positioniert. Die Werkzeugaufnahme 5 dient zum Aufnehmen und Halten eines Werkzeugs 8. In dem vorliegenden Ausführungsbeispiels ist das Werkzeug 8 als Bit (auch Schrauben-Bit bezeichnet) ausgestaltet.

Im Inneren des Werkzeuggehäuses 4 ist im Wesentlichen ein Antrieb, ein Getriebe, eine Steuerungseinrichtung 9, eine erste Vorrichtung zum Ermitteln eines Spannungswertes 31a, eine erste Vorrichtung zum Ermitteln eines Stromstärkewertes 32a, eine erste Speichereinheit 33a und eine Antriebswelle positioniert.

In dem vorliegenden Ausführungsbeispiel enthält die Steuerungseinrichtung 9 die erste Vorrichtung zum Ermitteln eines Spannungswertes 31a, die erste Vorrichtung zum Ermitteln eines Stromstärkewertes 32a sowie die erste Speichereinheit 33a.

Die Vorrichtung zum Ermitteln eines Spannungswertes 31a dient zum Ermitteln elektrischer Spannungen kann auch als Spannungsmessgerät, Spannungsmesser oder Voltmeter bezeichnet werden.

Die Vorrichtung zum Ermitteln eines Stromstärkewertes 32a dient zum Ermitteln der elektrischen Stromstärke und kann auch als Strommessgerät, Strommesser oder Amperemeter bezeichnet werden.

Alternativ kann die erste Vorrichtung zum Ermitteln eines Spannungswertes 31a, die erste Vorrichtung zum Ermitteln eines Stromstärkewertes 32a oder die erste Speichereinheit 33a auch an einer anderen geeigneten Stelle in der Werkzeugmaschine 2 positioniert sein.

Die Speichereinheit 33a dient zum Speichern und Bereitstellen von Daten und Informationen und ist über eine entsprechende Leitung S jeweils mit der Vorrichtung zum Ermitteln eines Spannungswertes 31a, die erste Vorrichtung zum Ermitteln eines Stromstärkewertes 32a und dem ersten Transceiver 14 verbunden.

Der Antrieb, das Getriebe sowie die Antriebswelle sind im Inneren des Gehäuses der Werkzeugmaschine so zueinander angeordnet, dass ein von dem Antrieb erzeugtes Drehmoment über das Getriebe auf die Antriebswelle übertragen werden kann. Die Antriebswelle ist wiederum mit der Werkzeugaufnahme 5 verbunden, sodass das Drehmoment auch auf die Werkzeugaufnahme 5 und schließlich auf das als Bit ausgestaltete Werkzeug 8 übertragen werden kann.

Der Antrieb ist als bürstenloser Elektromotor ausgestaltet. Alternativ kann der Antrieb aber auch als Elektromotor mit Kohlebürsten ausgestaltet sein.

Weder der Antrieb, das Getriebe noch die Antriebswelle sind in den Figuren dargestellt.

An der Unterseite 4d des Werkzeugmaschinengehäuses 4 ist das obere Ende 6a des Handgriffs 6 befestigt.

An dem unteren Ende 6b des Handgriffs 6 ist eine Fußvorrichtung 10 positioniert, die eine Werkzeugmaschinenschnittstelle 11 enthält. Die Werkzeugmaschinenschnittstelle 11 dient zum wiederlösbaren Verbinden des Akkumulators 3 mit der Werkzeugmaschine 2.

Die Werkzeugmaschinenschnittstelle 11 enthält wiederum einen ersten Leistungsanschluss 15a, einen zweiten Leistungsanschluss 16a sowie ein erster Kommunikationskontakt 12a. In dem vorliegenden Ausführungsbeispiel ist der erste Leistungsanschluss 15a in Form eines Pluskontakts und der zweite Leistungsanschluss 16a in Form eines Minuskontakts ausgestaltet. Alternativ kann der erste Leistungsanschluss 15a auch zwei oder mehr Pluskontakte und der zweite Leistungsanschluss 16a auch zwei oder mehr Minuskontakte enthalten.

Wie später noch im Detail beschrieben dient der als Pluskontakt ausgestaltete erste Leistungsanschluss 15a und der als Minuskontakt ausgestaltete zweite Leistungsanschluss 16a zum Erzeugen eines Stromkreises, damit elektrische Energie von dem Akkumulator 3 zu der Werkzeugmaschine 2 gelangen kann.

Der erste Leistungsanschluss 15a ist durch eine erste Leitung L1 mit der ersten Vorrichtung zum Ermitteln eines Spannungswertes 31a und durch eine zweite Leitung L2 mit der ersten Vorrichtung zum Ermitteln eines Stromstärkewertes 32a verbunden. Durch die erste und zweite Leitung L1, L2 können an dem ersten Leistungsanschluss 15a ein Spannungswert und Stromstärkewert ermittelt werden. Des Weiteren ist der zweite Leistungsanschluss 16a durch eine dritte Leitung L3 mit der ersten Vorrichtung zum Ermitteln eines Spannungswertes 31 und durch eine vierte Leitung L4 mit der ersten Vorrichtung zum Ermitteln eines Stromstärkewertes 32a verbunden. Durch die dritte und vierte Leitung L3, l4 kön-

nen an dem zweiten Leistungsanschluss 16a ein Spannungswert und Stromstärkewert ermittelt werden.

Die jeweilige Leitung L1, L2, L3, L4 kann auch als elektrische Leitung, elektrischer Leiter oder Litze bezeichnet werden.

Der erste Kommunikationskontakt 12 der Werkzeugmaschine 2 ist Bestandteil einer drahtgebundenen Übertragungseinrichtung 13 zum Austauschen von Daten und Informationen von der Werkzeugmaschine 2 mit einem anderen Kommunikationspartner (beispielsweise der Akkumulator 3).

Die Steuerungseinrichtung 9 der Werkzeugmaschine 2 ist in dem vorliegenden Ausführungsbeispiel im Inneren des Handgriffs 6 positioniert. Alternativ kann die Steuerungseinrichtung 9 auch an einer anderen geeigneten Stelle in oder an der Werkzeugmaschine 2 positioniert sein. Die Steuerungseinrichtung 9 dient zum Steuern und Regeln der unterschiedlichen Funktionen der Werkzeugmaschine 2.

Des Weiteren enthält die Steuerungseinrichtung 9 einen ersten Transceiver 14.

Der erste Transceiver 14 ist Bestandteil der drahtgebundenen Übertragungseinrichtung 13 zum Austauschen von Daten und Informationen der Werkzeugmaschine 2 mit einem anderen Kommunikationspartner. Hierzu ist der erste Transceiver 14 durch eine erste Kommunikationsleitung 34 mit dem ersten Kommunikationskontakt 12 der Werkzeugmaschine 2 so verbunden, dass Daten und Informationen in Form von Signalen zwischen dem ersten Transceiver 14 und dem ersten Kommunikationskontakt 12 der Werkzeugmaschine 2 ausgetauscht werden können.

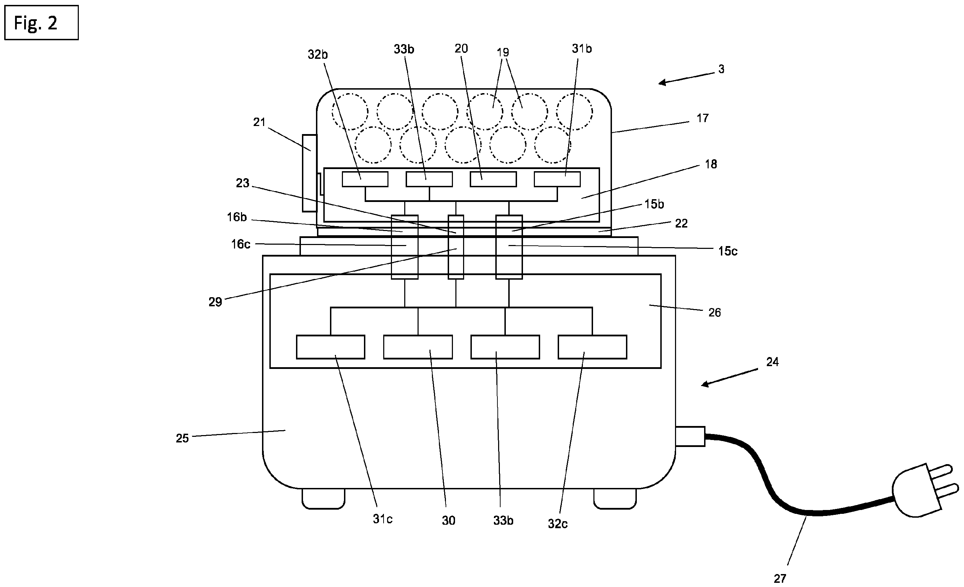

Der in Figur 1 und 2 dargestellt Akkumulator 3 enthält gemäß dem dargestellten Ausführungsbeispiel im Wesentlichen ein Akkugehäuse 17, eine zweite Vorrichtung zum Ermitteln eines Spannungswertes 31b, eine zweite Vorrichtung zum Ermitteln eines Stromstärkewertes 32b, eine zweite Speichereinheit 33b, eine Steuerungseinrichtung 18 und eine Anzahl eines Energiespeicherzellen 19 (auch Akku-Zellen genannt).

In dem vorliegenden Ausführungsbeispiel enthält die Steuerungseinrichtung 18 des Akkumulators 3 die zweite Vorrichtung zum Ermitteln eines Spannungswertes 31b, die zweite Vorrichtung zum Ermitteln eines Stromstärkewertes 32b sowie die zweite Speichereinheit 33b. Die Vorrichtung zum Ermitteln eines Spannungswertes 31b dient zum Ermitteln elektrischer Spannungen kann auch als Spannungsmessgerät, Spannungsmesser oder Voltmeter bezeichnet werden.

Die Vorrichtung zum Ermitteln eines Stromstärkewertes 32b dient zum Ermitteln der elektrischen Stromstärke und kann auch als Strommessgerät, Strommesser oder Amperemeter bezeichnet werden.

Alternativ kann die zweite Vorrichtung zum Ermitteln eines Spannungswertes 31b, die zweite Vorrichtung zum Ermitteln eines Stromstärkewertes 32b oder die zweite Speichereinheit 33b auch an einer anderen geeigneten Stelle in der Werkzeugmaschine 2 positioniert sein.

Die zweite Speichereinheit 33b dient zum Speichern und Bereitstellen von Daten und Informationen und ist über eine entsprechende Leitung S jeweils mit der Vorrichtung zum Ermitteln eines Spannungswertes 31b, die erste Vorrichtung zum Ermitteln eines Stromstärkewertes 32b und dem ersten Transceiver 20 verbunden.

Die Energiespeicherzellen 19 sind im Inneren des Akkugehäuses 17 positioniert und dienen zum Aufnehmen, Speichern sowie Bereitstehen einer elektrischen Energie. Jede einzelne Energiespeicherzelle 19 ist über eine entsprechende Leitung mit der Steuerungseinrichtung 18 verbunden. Die Leitung zwischen den einzelnen Energiespeicherzelle 19 und der Steuerungseinrichtung 18 ist in den Figuren nicht gezeigt. Darüber hinaus sind die Energiespeicherzellen 19 mit einem als Pluskontakt ausgestalteten dritten Leistungsanschluss 15b und einem als Minuskontakt ausgestalteten vierten Leistungsanschluss 16b des Akkumulators 3 verbunden, sodass die in den Energiespeicherzelle 19 gespeicherte elektrische Energie an dem Pluskontakt und Minuskontakt abgreifbar ist.

Die Steuerungseinrichtung 18 dient zum Steuern und Regeln der unterschiedlichen Funktionen des Akkumulators 3. Des Weiteren enthält die Steuerungseinrichtung 18 einen zweiten Transceiver 20.

Der zweite Transceiver 20 des Akkumulators 3 ist Bestandteil der drahtgebundenen Übertragungseinrichtung 13 zum Austauschen von Daten und Informationen des Akkumulators 3 mit einem anderen Kommunikationspartner (beispielsweise der Werkzeugmaschine 2 oder der Ladevorrichtung 24).

Hierzu ist der zweite Transceiver 20 durch eine zweite Kommunikationsleitung 35 mit dem ersten Kommunikationskontakt 23 des Akkumulators 3 so verbunden, dass Daten und Informationen in Form von Signalen zwischen dem zweiten Transceiver 20 und dem zweiten Kommunikationskontakt 23 des Akkumulators 3 ausgetauscht werden können.

Das Akkugehäuse 17 enthält an einer Oberseite 17a eine Akkuschnittstelle 22, welche zu der Werkzeugschnittstelle 11 korrespondierend ausgestaltet ist und dazu dient, den Akkumulator 3 mit der Werkzeugmaschine 2 wiederlösbar zu verbinden.

Die Akkuschnittstelle 22 enthält wiederum den als Pluskontakt ausgestalteten dritten Leistungsanschluss 15b, den als Minuskontakt ausgestalteten vierten Leistungsanschluss 16b sowie ein zweiten Kommunikationskontakt 23.

Zum Verbinden des Akkumulators 3 mit der Werkzeugmaschine 2 wird die Akkuschnittstelle 22 mit der Werkzeugmaschinenschnittstelle 11 so in Kontakt gebracht, dass die jeweiligen Leistungsanschlüsse 15a, 15b, 16a, 16b (d.h. die jeweiligen Plus- und Minuskontakte) und Kommunikationskontakte 12, 23 miteinander in Verbindung stehen. Durch die Kontaktierung der Leistungsanschlüsse 15a, 15b, 16a, 16b kann ein Stromkreis so geschlossen werden, dass elektrische Energie von den Energiespeicherzellen 19 des Akkumulators 3 über die jeweiligen Schnittstellen 11, 22 zu der Werkzeugmaschine 2 gelangen kann.

Der dritte Leistungsanschluss 15b ist durch eine fünfte Leitung L5 mit der zweiten Vorrichtung zum Ermitteln eines Spannungswertes 31b und durch eine sechste Leitung L6 mit der zweiten Vorrichtung zum Ermitteln eines Stromstärkewertes 32b verbunden. Durch die fünfte und sechste Leitung L5, L6 können an dem dritten Leistungsanschluss 15b ein Spannungswert und Stromstärkewert ermittelt werden. Des Weiteren ist der vierte Leistungsanschluss 16b durch eine siebte Leitung L7 mit der zweiten Vorrichtung zum Ermitteln eines Spannungswertes 31b und durch eine achte Leitung L8 mit der zweiten Vorrichtung zum Ermitteln eines Stromstärkewertes 32b verbunden. Durch die siebte und achte Leitung L7, L8 können an dem vierten Leistungsanschluss 16b ein Spannungswert und Stromstärkewert ermittelt werden.

Die jeweilige Leitung L5 - L8 kann auch als elektrische Leitung, elektrischer Leiter oder Litze bezeichnet werden.

Dadurch, dass der erste Kommunikationskontakt 12 der Werkzeugmaschine 2 sowie der zweite Kommunikationskontakt 23 des Akkumulators 3 in Verbindung gebracht werden, können Daten und Informationen in Form von Signalen zwischen dem Akkumulator 3 und der Werkzeugmaschine 2 ausgetauscht werden.

Figur 2 zeigt ein erfindungsgemäßes System gemäß eines zweiten Ausführungsbeispiels mit einer ersten Systemkomponente und einer zweiten Systemkomponente. Die erste Systemkomponente ist in Form einer Ladevorrichtung 24 und die zweite Systemkomponente ist in Form des Akkumulators 3 ausgestaltet.

Die Ladevorrichtung 24 dient zum Versorgen eines angeschlossenen Akkumulators 3 mit elektrischer Energie und enthält dabei im Wesentlichen ein Ladevorrichtungsgehäuse 25, eine Steuerungseinrichtung 26, eine dritte Vorrichtung zum Ermitteln eines Spannungswertes 31c, eine dritte Vorrichtung zum Ermitteln eines Stromstärkewertes 32c, eine dritte Speichereinheit 33c und eine Energieversorgung 27.

Die Speichereinheit 33c dient zum Speichern und Bereitstellen von Daten und Informationen und ist über eine entsprechende Leitung S jeweils mit der Vorrichtung zum Ermitteln eines Spannungswertes 31c, die erste Vorrichtung zum Ermitteln eines Stromstärkewertes 32c und dem ersten Transceiver 30 verbunden.

In dem vorliegenden Ausführungsbeispiel enthält die Steuerungseinrichtung 26 die dritte Vorrichtung zum Ermitteln eines Spannungswertes 31c, die dritte Vorrichtung zum Ermitteln eines Stromstärkewertes 32c sowie die dritte Speichereinheit 33c.

Die Vorrichtung zum Ermitteln eines Spannungswertes 31c dient zum Ermitteln elektrischer Spannungen kann auch als Spannungsmessgerät, Spannungsmesser oder Voltmeter bezeichnet werden.

Die Vorrichtung zum Ermitteln eines Stromstärkewertes 32c dient zum Ermitteln der elektrischen Stromstärke und kann auch als Strommessgerät, Strommesser oder Amperemeter bezeichnet werden.

Alternativ kann die dritte Vorrichtung zum Ermitteln eines Spannungswertes 31c, die dritte Vorrichtung zum Ermitteln eines Stromstärkewertes 32c oder die dritte Speichereinheit 33c auch an einer anderen geeigneten Stelle in der Ladevorrichtung 24 positioniert sein.

Des Weiteren enthält das Ladevorrichtungsgehäuse 25 an einer Oberseite 25a eine Ladevorrichtungsschnittstelle 28, die zum wiederlösbaren Verbinden der Ladevorrichtung 24 mit dem Akkumulator 3 dient.

Die Ladevorrichtungsschnittstelle 28 enthält wiederum einen als Pluskontakt ausgestalteten fünften Leistungsanschluss 15c, einen als Minuskontakt ausgestalteten sechsten Leistungsanschluss 16c sowie ein dritten Kommunikationskontakt 29. Der Pluskontakt und der Minuskontakt dienen zum Erzeugen eines Stromkreises damit elektrische Energie von der Ladevorrichtung 24 zu dem Akkumulator 3, insbesondere zu den Energiespeicherzellen 19, gelangen kann.

Der fünfte Leistungsanschluss 15c ist durch eine neunte Leitung L9 mit der dritten Vorrichtung zum Ermitteln eines Spannungswertes 31c und durch eine zehnte Leitung L10 mit der dritten Vorrichtung zum Ermitteln eines Stromstärkewertes 32c verbunden. Durch die neunte und zehnte Leitung L10 können an dem fünften Leistungsanschluss 15c ein Spannungswert und Stromstärkewert ermittelt werden. Des Weiteren ist der sechste Leistungsanschluss 16c durch eine elfte Leitung L11 mit der dritten Vorrichtung zum Ermitteln eines Spannungswertes 31c und durch eine zwölfte Leitung L12 mit der dritten Vorrichtung zum Ermitteln eines Stromstärkewertes 32c verbunden. Durch die elfte und zwölfte Leitung L11, L12 können an dem sechsten Leistungsanschluss 16c ein Spannungswert und Stromstärkewert ermittelt werden.

Die jeweilige Leitung L9 - L12 kann auch als elektrische Leitung, elektrischer Leiter oder Litze bezeichnet werden.

Der dritte Kommunikationskontakt 29 der Ladevorrichtung 24 ist Bestandteil einer drahtgebundenen Übertragungseinrichtung 13 zum Austauschen von Daten und Informationen von der Ladevorrichtung 24 mit einem anderen Kommunikationspartner (beispielsweise der Akkumulator 3).

Die Steuerungseinrichtung 26 dient zum Steuern und Regeln der verschiedenen Funktionen der Ladevorrichtung 24. Darüber hinaus enthält die Steuerungseinrichtung 26 einen dritten Transceiver 30.

Der dritte Transceiver 30 ist Bestandteil einer drahtgebundenen Übertragungseinrichtung 13 zum Austauschen von Daten und Informationen der Ladevorrichtung 24 mit einem anderen Kommunikationspartner. Hierzu ist der erste Transceiver 30 durch eine dritte Kommunikationsleitung 36 mit dem drittem Kommunikationskontakt 29 der Ladevorrichtung 24 so verbunden, dass Daten und Informationen in Form von Signalen zwischen dem dritten Transceiver 30 und dem drittem Kommunikationskontakt 29 der Ladevorrichtung 24 ausgetauscht werden können.

Wie in Figur 2 erkennbar ist die Energieversorgung 27 in Form eines Stromkabels ausgestaltet. Mit Hilfe der als Stromkabel ausgestalteten Energieversorgung 27 kann die Ladevorrichtung 24 an ein Stromnetz (d.h. Steckdose) angeschlossen werden.

Alternativ kann die Ladevorrichtung 24 auch in Form einer mobilen Energieversorgungseinrichtung verwirklicht sein. Derartige mobile Energieversorgungseinrichtungen können auch als Powerbank bezeichnet werden.

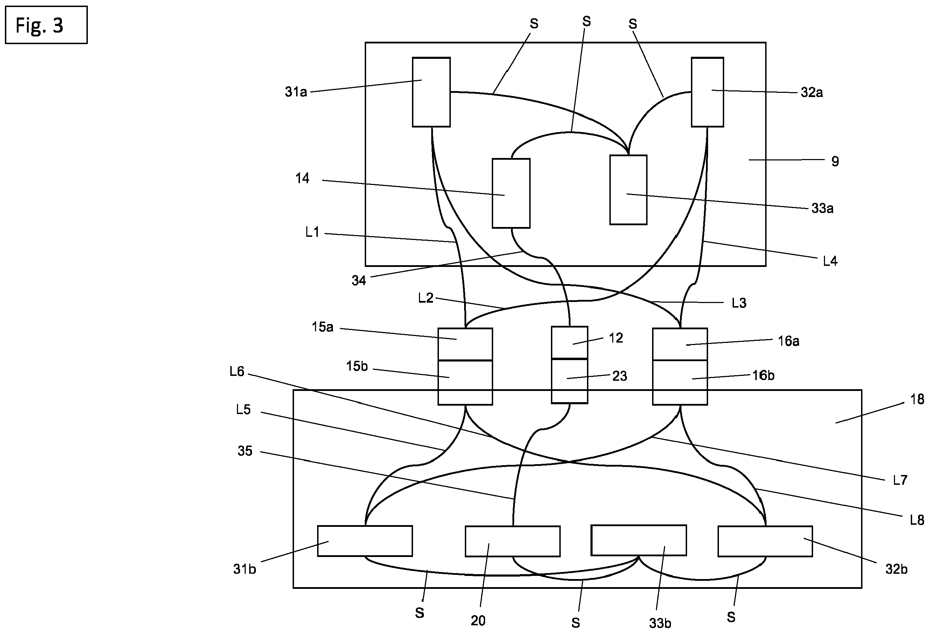

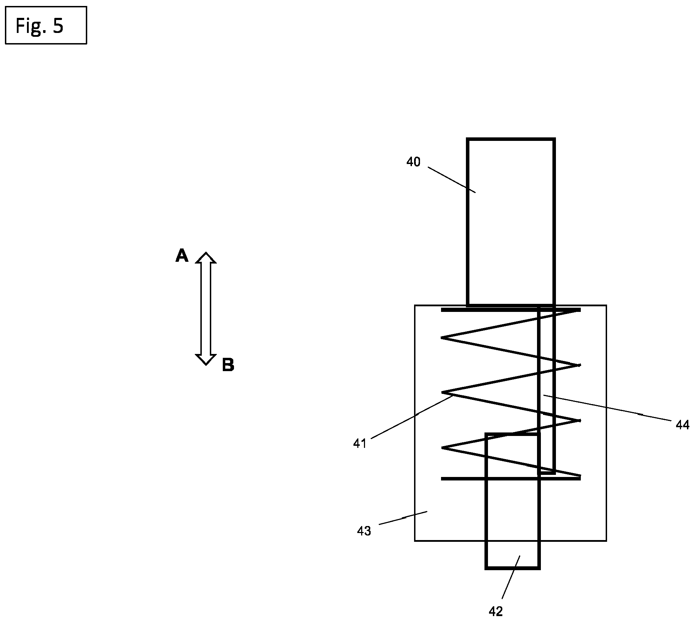

In den Figuren 3 bis 5 ist beispielhaft ein Leistungsanschluss gezeigt. Der in den Figuren 3 bis 5 gezeigte Leistungsanschluss entspricht dabei in der Ausgestaltung dem ersten bis sechsten Leistungsanschluss 15a, 15b, 16a, 16b, 15c, 16c.

Der Leistungsanschluss 15a, 15b, 16a, 16b, 15c, 16c enthält dabei jeweils im Wesentlichen ein erstes Kontaktelement 40, ein Federelement 41, ein zweites Kontaktelement 42, ein Kontaktgehäuse 43 und eine elektrische Verbindungsleitung 44.

Das erste Kontaktelement 40 ist an einem oberen Ende des Kontaktgehäuses 43 positioniert. Das zweite Kontaktelement 42 ist an einem unteren Ende des Kontaktgehäuses 43 positioniert, sodass das zweite Kontaktelement 42 teilweise aus dem Kontaktgehäuse 43 herausragt. Das Federelement 41 verbindet das erste und zweite Kontaktelement 40, 42 so miteinander, dass das erste und zweite Kontaktelement 40, 42 in Richtung A oder B relativ zueinander bewegt werden können. Die Verbindungsleitung 44 verbindet das erste und zweite Kontaktelement 40, 42 so miteinander und ist dabei so ausgestaltet, dass eine elektrische Verbindung zwischen dem ersten und zweiten Kontaktelement 40, 42 besteht. Durch die elektrische Verbindungsleitung 44 kann elektrische Energie zwischen dem ersten und zweiten Kontaktelement 40, 42 transportiert werden. Die elektrische Verbindungsleitung 44 ist wenigstens so lang ausgestaltet, dass der gesamte Federweg des Federelements 41 in Richtung A oder B ausgeführt werden kann.

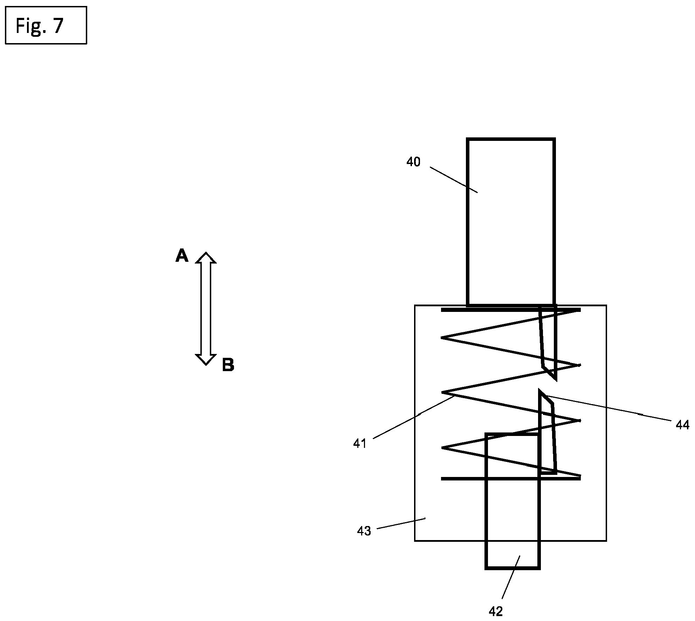

Figur 7 zeigt dabei den beispielhaft ausgestalteten Leistungsanschluss 15a, 15b, 16a, 16b, 15c, 16c in einem ersten Zustand. Bei dem ersten Zustand handelt es sich um einen ursprünglichen, unveränderten bzw. unbeschädigten Zustand des Leistungsanschlusses 15a, 15b, 16a, 16b, 15c, 16c. Wie erkennbar, weist die elektrische Verbindungsleitung 44 zwischen dem ersten und zweiten Kontaktelement 40, 42 einen durchgehend konstanten Durchmesser bzw. eine konstante Querschnittsfläche auf.

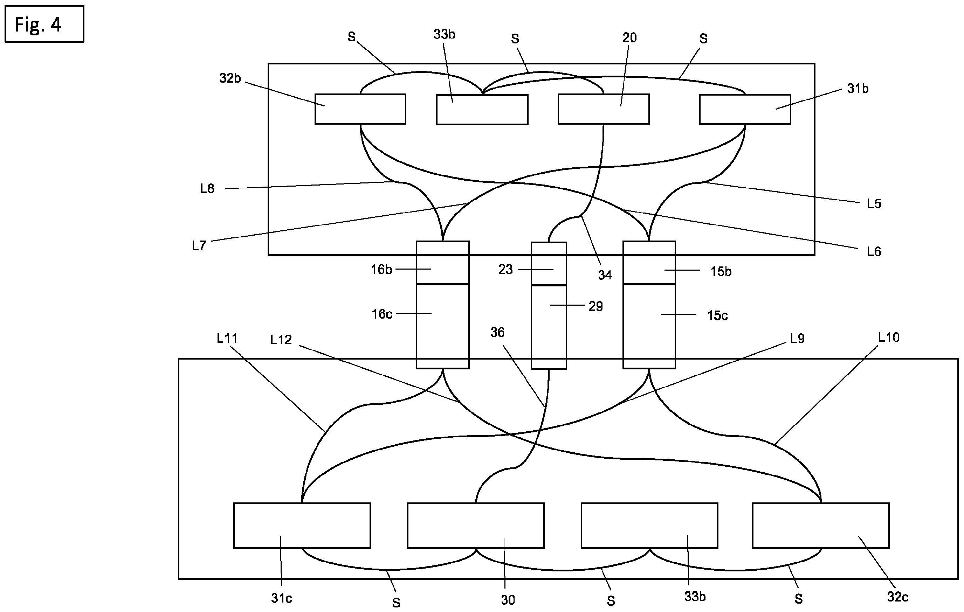

Figur 4 zeigt den beispielhaft ausgestalteten Leistungsanschluss 15a, 15b, 16a, 16b, 15c, 16c in einem zweiten Zustand. Bei dem zweiten Zustand handelt es sich um einen im Gegensatz zum ersten Zustand veränderten bzw. beschädigten Zustand des Leistungsanschluss 15a, 15b, 16a, 16b, 15c, 16c, bei dem die elektrische Verbindungsleitung 44 zwischen dem ersten und zweiten Kontaktelement 40, 42 einen verengten Abschnitt mit einem verkleinerten Durchmesser bzw. einer reduzierten Querschnittsfläche aufweist. Der zweite bzw. beschädigte Zustand des Leistungsanschluss 15a, 15b, 16a, 16b, 15c, 16c ist Folge einer erhöhten mechanischen Belastung aufgrund von Vibrationen oder Erschütterungen an dem Leistungsanschluss 15a, 15b, 16a, 16b, 15c, 16c.

Figur 7 zeigt den beispielhaft ausgestalteten Leistungsanschluss 15a, 15b, 16a, 16b, 15c, 16c in einem dritten Zustand. Bei dem dritten Zustand handelt es sich ebenfalls um einen im Gegensatz zum ersten Zustand veränderten bzw. beschädigten Zustand des Leistungsanschluss 15a, 15b, 16a, 16b, 15c, 16c. Im Gegensatz zu dem zweiten Zustand ist bei dem dritten Zustand die elektrische Verbindungsleitung 44 durchbrochen, sodass keine elektrische Energie mehr durch die elektrische Verbindungsleitung 44 und insbesondere nicht mehr zwischen dem ersten und zweiten Kontaktelement 40, 42 austausch werden kann.

Zum Ermitteln des Zustands eines elektrischen Leiters kann die Konduktivität des elektrischen Leiters an einem Leistungsanschluss 15a, 15b, 16a, 16b, 15c, 16c bestimmt werden. Zur Durchführung des Verfahrens wird zunächst ein erster Spannungswert und zweiter Spannungswert an der Werkzeugmaschine 2 bei einem im Wesentlichen konstanten Stromstärkewert ermittelt. Der erste Spannungswert kann beispielsweise 21,992 V (V = Volt) und der zweite Spannungswert kann beispielsweise 21,2 V betragen. Der konstante Stromstärkewert beträgt 8 A (A = Ampere). Das Ermitteln der Spannungswerte erfolgt durch die erste Vorrichtung zum Ermitteln eines Spannungswertes der Werkzeugmaschine 2 und während sich die Werkzeugmaschine 2 in einem Aktivierungszustand befindet, d.h. wenn ein mit der Werkzeugmaschine 2 verbundener Akkumulator 3 elektrische Energie zur Werkzeugmaschine 2 liefert.

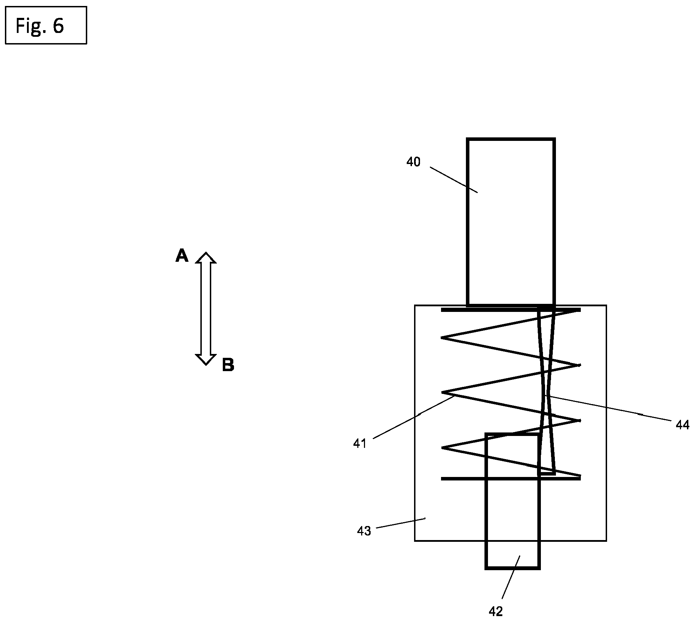

Der ermittelte zweite Spannungswert (= 21,2 V) ist im Verhältnis zum ersten Spannungswert (= 21,992 V) niedriger, da in dem Zeitraum zwischen dem Ermitteln des ersten Spannungswert und des zweiten Spannungswerts eine Änderung an der Konduktivität des elektrischen Leiters und insbesondere an dem Leistungsanschluss 15a, 15b, 16a, 16b, 15c, 16c eingetreten ist. Zu dem Zeitpunkt des Ermittelns des ersten Spannungswerts befand sich die elektrische Verbindungsleitung 44 zwischen dem ersten und zweiten Kontaktelement des Leistungsanschluss 15a, 15b, 16a, 16b, 15c, 16c noch in einem ursprünglichen, unveränderten bzw. unbeschädigten Zustand, sodass eine relativ hohe Konduktivität und ein relativ niedriger elektrischer Widerstand an der elektrischen Verbindungsleitung 44 bestand, vgl. Figur 7. Zu dem Zeitpunkt des Ermittelns des zweiten Spannungswerts befand sich die elektrische Verbindungsleitung 44 zwischen dem ersten und zweiten Kontaktelement 40, 42 des Leistungsanschluss 15a, 15b, 16a, 16b, 15c, 16c jedoch in verändertem bzw. beschädigten Zustand, wobei sich die Querschnittsfläche der elektrischen Verbindungsleitung 44 reduziert hat, wodurch sich die Konduktivität verschlechtert und der elektrische Widerstand an der elektrischen Verbindungsleitung 44 erhöht hat, vgl. Figur 6.

Ein extremes Beispiel ist in Figur 7 gezeigt, bei dem die elektrische Verbindungsleitung 44 komplett durchbrochen und folglich keine Konduktivität mehr besteht.

In einem nächsten Verfahrensschritt wird ein erster Differenzwert zwischen einem Nennspannungswert an dem Akkumulator 3 und dem ersten Spannungswert ermittelt. Der Nennspannungswert kann beispielsweise 22 V betragen. Der erste Differenzwert zwischen einem Nennspannungswert an dem Akkumulator 3 und dem ersten Spannungswert beträgt daher in dem vorliegenden Ausführungsbeispiel 0,008 V.

Als nächstes wird ein zweiter Differenzwertes zwischen dem Nennspannungswert an Akkumulator 3 und dem zweiten Spannungswert ermittelt. Der zweite Differenzwert zwischen dem Nennspannungswert (= 22 V) an dem Akkumulator 3 und dem zweiten Spannungswert (= 21,2 V) beträgt daher in dem vorliegenden Ausführungsbeispiel 0,8 V.

In einem nächsten Verfahrensschritt wird ein Übergangwiderstand als Quotient aus dem zweiten Differenzwert (= 0,8 V) und dem Stromstärkewert (= 8 A) ermittelt, wenn ein Unterscheid zwischen dem ersten und zweiten Differenzwert einen vorbestimmten Schwellwert erreicht. In dem vorliegenden Ausführungsbeispiel beträgt der vorbestimmte Schwellwert 0,1 V. Alternativ kann auch ein höherer oder niedriger Schwellwert möglich sein. In dem vorliegenden Ausführungsbeispiel beträgt der Unterscheid zwischen dem ersten und zweiten Differenzwert 0,792 V.

Der Übergangwiderstand als Quotient aus dem zweiten Differenzwert (= 0,8 V) und dem Stromstärkewert (= 8 A) beträgt in dem vorliegenden Ausführungsbeispiel 0,1 Ω.

$$0,8\ V\ /\ 8\ A = 0,1\ \Omega$$

In einem weiteren Verfahrensschritt wird der Akkumulator 3 von ersten Betriebszustand in einen zweiten Betriebszustand eingestellt, wenn der ermittelte Übergangwiderstand einen vorbestimmten Schwellwert erreicht. In dem vorliegenden Ausführungsbeispiel beträgt der vorbestimmte Schwellwert für den Übergangwiderstand 0,05 Ω. Dadurch, dass der ermittelte Übergangwiderstand 0,1 Ω beträgt kann ermittelt werden, dass eine Änderung an der elektrischen Verbindungsleitung 44 und insbesondere an dem Leistungsanschluss 15a, 15b, 16a, 16b, 15c, 16c geschehen ist, die Einfluss auf den elektrischen Widerstand bzw. die Konduktivität hat. Als Folge daraus wird der Akkumulator 3 von einem Aktivierungsmodus (= erster Betriebszustand) in einen Deaktivierungsmodus (= zweiter Betriebszustand) gestellt. In den Deaktivierungszustand wird keine elektrische Energie von dem Akkumulator 3 zu der Werkzeugmaschine 2 geleitet.

Alternativ oder als Ergänzung hierzu wird an einer Anzeigevorrichtung 21 des Akkumulators 3 die Änderung des Betriebszustands angezeigt. Zum Anzeigen einer entsprechenden Information an der Anzeigevorrichtung 21 des Akkumulators 3 wird ein Signal von der Steuerungseinrichtung 18 an die Anzeigevorrichtung 21 gesendet.

Es ist zu verstehen, dass das vorstehend beschriebene Verfahren zum Bestimmen der Konduktivität eines elektrischen Leiters auch anwendbar ist, wenn die erste Systemkomponente durch den Akkumulator 3 und die zweite Systemkomponente durch die Ladevorrichtung 24 ausgestaltet ist.

## Bezugszeichenliste

| 1 | System |
|---|---|
| 2 | Werkzeugmaschine |
| 3 | Akkumulator |
| 4 | Werkzeugmaschinengehäuse |
| 4a | vorderes Ende des Werkzeugmaschinengehäuses |
| 4b | hinteres Ende Werkzeugmaschinengehäuses |
| 4c | Oberseite des Werkzeugmaschinengehäuses |
| 4d | Unterseite des Werkzeugmaschinengehäuses |
| 5 | Werkzeugaufnahme |
| 6 | Handgriff |
| 6a | erstes Ende des Handgriffs |
| 6b | zweites Ende des Handgriffs |
| 6c | Vorderseite 6c des Handgriffs |
| 7 | Aktivierungsschalter |
| 8 | Werkzeugaufnahme |
| 9 | Steuerungseinrichtung der Werkzeugmaschine |
| 10 | Fussvorrichtung |
| 11 | Werkzeugmaschinenschnittstelle |
| 12 | erster Kommunikationskontakt der Werkzeugmaschine |
| 13 | drahtgebundene Übertragungseinrichtung |
| 14 | erster Transceiver der Werkzeugmaschine |
| 15a | erster Leistungsanschluss der Werkzeugmaschine |
| 16a | zweiter Leistungsanschluss der Werkzeugmaschine |
| 15b | dritter Leistungsanschluss des Akkumulators |
| 16b | vierter Leistungsanschluss des Akkumulators |
| 15c | fünfte Leistungsanschluss der Ladevorrichtung |
| 16c | sechster Leistungsanschluss der Ladevorrichtung |
| 17 | Akkugehäuse |
| 18 | Steuerungseinrichtung des Akkumulators |
| 19 | Energiespeicherzelle |
| 20 | zweiter Transceiver des Akkumulators |

| | |
|---|---|
| 21 | Anzeigevorrichtung |
| 22 | Akkuschnittstelle |
| 23 | zweiter Kommunikationskontakt des Akkumulators |
| 24 | Ladevorrichtung |
| 25 | Ladevorrichtungsgehäuse |
| 26 | Steuerungseinrichtung der Ladevorrichtung |
| 27 | Energieversorgung der Ladevorrichtung |
| 28 | Ladevorrichtungsschnittstelle |
| 29 | dritter Kommunikationskontakt der Ladevorrichtung |
| 30 | dritter Transceiver der Ladevorrichtung |
| 31a | erste Vorrichtung zum Ermitteln eines Spannungswertes der Werkzeugmaschine |
| 32a | erste Vorrichtung zum Ermitteln eines Stromstärkewertes der Werkzeugmaschine |
| 33a | erste Speichereinheit der Werkzeugmaschine |
| 31b | zweite Vorrichtung zum Ermitteln eines Spannungswertes des Akkumulators |
| 32b | zweite Vorrichtung zum Ermitteln eines Stromstärkewertes des Akkumulators |
| 33b | zweite Speichereinheit des Akkumulators |
| 31c | dritte Vorrichtung zum Ermitteln eines Spannungswertes der Ladevorrichtung |
| 32c | dritte Vorrichtung zum Ermitteln eines Stromstärkewertes der Ladevorrichtung |
| 33c | dritte Speichereinheit der Ladevorrichtung |
| 34 | erste Kommunikationsleitung |
| 35 | zweite Kommunikationsleitung |
| 36 | dritte Kommunikationsleitung |
| 40 | erstes Kontaktelement |
| 41 | Federelement |
| 42 | zweites Kontaktelement |
| 43 | Kontaktgehäuse |
| 44 | Verbindungsleitung |
| | |
| L1 | erste Leitung |
| L2 | zweite Leitung |
| L3 | dritte Leitung |
| L4 | vierte Leitung |
| L5 | fünfte Leitung |
| L6 | sechste Leitung |
| L7 | siebte Leitung |
| L8 | achte Leitung |
| L9 | neunte Leitung |
| L10 | zehnte Leitung |
| L11 | elfte Leitung |
| L12 | zwölfte Leitung |
| | |
| S | Leitung von und zu der Speichereinheit |

**Patentansprüche**

1. Verfahren zum Bestimmen der Konduktivität eines elektrischen Leiters (L1 - L12) zwischen einer erster Systemkomponente und einer zweiten Systemkomponente, wobei die erste und zweite Systemkomponente voneinander wiederlösbare Bestandteile eines Systems (1) sind und wobei die erste Systemkomponente beispielsweise in Form eines Akkumulators (3) und die zweite Systemkomponente beispielsweise in Form einer mit dem Akkumulator (3) verbindbaren Werkzeugmaschine (2) oder einer mit dem Akkumulator (3) verbindbaren Ladevorrichtung (24) ausgestaltet ist,
**gekennzeichnet durch** die Verfahrensschritte

   - Ermitteln eines ersten Spannungswertes und zweiten Spannungswertes an der ersten oder zweiten Systemkomponente bei einem gegebenen Stromstärkewert;
   - Ermitteln eines ersten Differenzwertes zwischen einem Referenzspannungswert an der ersten Systemkomponente und dem ersten Spannungswert;
   - Ermitteln eines zweiten Differenzwertes zwischen einem Referenzspannungswert an der ersten Systemkomponente und dem zweiten Spannungswert;
   - Bestimmen eines Übergangwiderstands als Quotient aus dem zweiten Differenzwert und dem Stromstärkewert, wenn ein Unterscheid zwischen dem ersten und zweiten Differenzwert einen vorbestimmten Schwellwert erreicht; und
   - Einstellen der ersten und/oder zweiten Systemkomponente von einem ersten Betriebszustand in einen zweiten Betriebszustand und/oder Aussenden wenigstens eines Signals durch eine Anzeigevorrichtung (21) an der ersten und/oder zweiten Systemkomponente, wenn der Übergangwiderstand einen vorbestimmten Schwellwert erreicht.

2. Verfahren zum Bestimmen der Konduktivität nach Anspruch 1,
**gekennzeichnet durch** den Verfahrensschritt

   - Ermitteln eines ersten Spannungswertes und zweiten Spannungswertes an wenigstens einem Leistungsanschluss (15a, 15b, 16a, 16b, 15c, 16c), wobei der wenigstens eine Leistungsanschluss (15a, 15b, 16a, 16b, 15c, 16c) ein Bestandteil der ersten Systemkomponente oder der zweiten Systemkomponente ist.

3. Verfahren zum Bestimmen der Konduktivität nach Anspruch 1 oder 2,
**dadurch gekennzeichnet, dass** das Ermitteln des zweiten Spannungswertes nach einer vorbestimmte Zeitdauer ab dem Ermitteln des ersten Spannungswertes erfolgt.

4. System (1) mit einer ersten und zweiten Systemkomponente zur Durchführung des Verfahrens nach wenigstens einem der Ansprüche 1 bis 3, wobei die erste Systemkomponente beispielsweise in Form eines Akkumulators (3) und die zweite Systemkomponente beispielsweise in Form einer mit dem Akkumulator (3) verbindbaren Werkzeugmaschine (2) oder einer mit dem Akkumulator (3) verbindbaren Ladevorrichtung (24) ausgestaltet ist,
**dadurch gekennzeichnet, dass** die erste und/oder zweite Systemkomponente eine Vorrichtung zum Ermitteln eines Spannungswertes (31a, 31b, 31c), eine Vorrichtung zum Ermitteln eines Stromstärkewertes (32a, 32b, 32c), eine Speichervorrichtung (33a, 33b, 33c) sowie eine Steuerungsvorrichtung (9, 18, 26) enthält.

Fig. 1

Fig. 2

Fig. 3

Fig. 4

EP 4 184 190 A1

Fig. 5

Fig. 6

Fig. 7

40
41
42
43
44

A B

Europäisches Patentamt
European Patent Office
Office européen des brevets

# EUROPÄISCHER RECHERCHENBERICHT

**Nummer der Anmeldung**

EP 21 20 9915

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 676 427 B1 (BLACK & DECKER INC [US]) 1. August 2012 (2012-08-01) | 4 | INV. G01R31/68 G01R27/20 |
| Y | * Absatz [0065] – Absatz [0070]; Abbildung 4B * | 1-3 | |
| X | DE 10 2014 202394 A1 (BOSCH GMBH ROBERT [DE]) 13. August 2015 (2015-08-13) | 1-4 | ADD. G01R27/16 B25F5/00 |
| Y | * Absätze [0013], [0024] – Absatz [0029]; Abbildungen 1,4 * * Absatz [0040] – Absatz [0056] * | 1-3 | |
| A | US 9 112 216 B2 (PARK KYU-HA [KR]; LG CHEMICAL LTD [KR]) 18. August 2015 (2015-08-18) * Spalte 5, Zeile 27 – Spalte 7, Zeile 14; Abbildungen 1,2,5,6 * | 1-4 | |
| A | DE 10 2018 202010 A1 (VOLKSWAGEN AG [DE]) 8. August 2019 (2019-08-08) * Absätze [0001], [0012] – Absatz [0038]; Abbildung 2 * | 1-4 | |
| A | US 10 084 214 B2 (ATIEVA INC [US]) 25. September 2018 (2018-09-25) * Spalte 5, Zeile 7 – Spalte 6, Zeile 33; Abbildungen 1,2 * | 1-4 | RECHERCHIERTE SACHGEBIETE (IPC) G01R B25H B25F |
| A | US 2006/192015 A1 (DIGIOVANNA ROBERT W [US]) 31. August 2006 (2006-08-31) * Absatz [0005] – Absatz [0010]; Abbildungen 2,3,6,7 * * Absatz [0035] – Absätze [0038], [0051], [0052] * | 1-4 | |

Der vorliegende Recherchenbericht wurde für alle Patentansprüche erstellt

| Recherchenort | Abschlußdatum der Recherche | Prüfer |
|---|---|---|
| München | 29. April 2022 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 21 20 9915

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-04-2022

| Im Recherchenbericht angeführtes Patentdokument | Datum der Veröffentlichung | Mitglied(er) der Patentfamilie | Datum der Veröffentlichung |
|---|---|---|---|
| EP 1676427 B1 | 01-08-2012 | AU 2004279384 A1 | 21-04-2005 |
| | | CA 2539217 A1 | 21-04-2005 |
| | | CN 1864300 A | 15-11-2006 |
| | | EP 1676427 A2 | 05-07-2006 |
| | | TW 200527793 A | 16-08-2005 |
| | | US 2005073282 A1 | 07-04-2005 |
| | | US 2008203995 A1 | 28-08-2008 |
| | | WO 2005034604 A2 | 21-04-2005 |
| DE 102014202394 A1 | 13-08-2015 | KEINE | |
| US 9112216 B2 | 18-08-2015 | CN 103283062 A | 04-09-2013 |
| | | EP 2642558 A2 | 25-09-2013 |
| | | JP 5997178 B2 | 28-09-2016 |
| | | JP 2014507757 A | 27-03-2014 |
| | | KR 20120080315 A | 17-07-2012 |
| | | US 2012280692 A1 | 08-11-2012 |
| | | WO 2012093788 A2 | 12-07-2012 |
| DE 102018202010 A1 | 08-08-2019 | CN 111699400 A | 22-09-2020 |
| | | DE 102018202010 A1 | 08-08-2019 |
| | | US 2020398774 A1 | 24-12-2020 |
| | | WO 2019154584 A1 | 15-08-2019 |
| US 10084214 B2 | 25-09-2018 | US 2014272497 A1 | 18-09-2014 |
| | | WO 2014144310 A1 | 18-09-2014 |
| US 2006192015 A1 | 31-08-2006 | AU 2006218906 A1 | 08-09-2006 |
| | | CA 2599367 A1 | 08-09-2006 |
| | | US 2006192015 A1 | 31-08-2006 |
| | | WO 2006093733 A2 | 08-09-2006 |

EPO FORM P0461

Für nähere Einzelheiten zu diesem Anhang : siehe Amtsblatt des Europäischen Patentamts, Nr.12/82